# EUROPEAN PATENT APPLICATION

(11) **EP 3 187 279 A1**
(43) Date of publication of application: **05.07.2017**
(21) Application number: 15836268.1
(22) Date of filing: 26.03.2015
(51) Int. Cl.: B22F 1/00, B22F 1/02, C09C 1/62, C09C 3/06, C09D 5/24, C09D 201/00, C23C 18/42, C25C 5/02, H01B 1/00, H01B 1/22, H01B 5/00

(54) **SILVER-COATED COPPER POWDER, AND CONDUCTIVE PASTE, CONDUCTIVE COATING MATERIAL AND CONDUCTIVE SHEET EACH OF WHICH USES SAME**

(30) Priority: 26.08.2014 JP 2014171781
(71) Applicant: Sumitomo Metal Mining Co., Ltd., Tokyo 105-8716 (JP)
(72) Inventor: OKADA, Hiroshi, Niihama-shi Ehime 792-0002 (JP); YAMASHITA, Hideyuki, Niihama-shi Ehime 792-0002 (JP)
(74) Representative: Jones, Nicholas Andrew
(86) International application number: PCT/JP2015/059486
(87) International publication number: WO 2016/031286

(57) **Abstract**

Provided is a dendritic silver-coated copper powder which is capable of effectively ensuring a contact, while having excellent electrical conductivity by having the surface coated with silver. This dendritic silver-coated copper powder has excellent uniform dispersibility that is necessary for the formation of a paste, and is suppressed in agglomeration. A silver-coated copper powder according to the present invention is obtained by coating the surface of a copper powder 1, which is an assembly of copper particles 2 and has a dendritic form having a plurality of branches, with silver. Each copper particle 2, the surface of which is coated with silver, is an ellipsoid that has a breadth within the range of from 0.2 µm to 0.5 µm and a length within the range of from 0.5 µm to 2.0 µm. The average particle diameter (D50) of the copper powder 1, which is obtained by coating the surface of the assembly of the ellipsoidal copper particles 2 with silver, is from 5.0 µm to 20 µm.

## Description

### TECHNICAL FIELD

The present invention relates to a copper powder (silver-coated copper powder) having a surface coated with silver, and more specifically it relates to a new dendritic silver-coated copper powder that is obtained by coating the surface of a dendritic copper powder composed of an assembly of fine copper particles having a single crystal structure with silver and can improve electrical conductivity by being used as a material such as an electrically conductive paste.

### BACKGROUND ART

A paste such as a resin type paste or a calcined type paste and a coating material such as an electromagnetic wave shielding coating material which use a metal filler such as a silver powder or a silver-coated copper powder are frequently used in the formation of a wiring layer, an electrode, and the like in an electronic device. In other words, it is possible to form an electrically conductive film to be a wiring layer or an electrode by applying or printing a metal filler paste of silver or silver-coated copper on various kinds of substrates and then subjecting the coated metal filler paste to heat curing or heat calcination.

For example, a resin type electrically conductive paste is composed of a metal filler, a resin, a curing agent, a solvent, and the like, and it is formed into an electrically conductive film by being printed on an electric conductor circuit pattern or a terminal and cured by heating at from 100°C to 200°C so as to form a wire and an electrode. In a resin type electrically conductive paste, the thermosetting resin is cured and shrunk by heat, and metal fillers are thus joined by pressure and brought into contact with one another to overlap each other, and as a result, an electrically connected current path is formed. This resin type electrically conductive paste is treated at a curing temperature of 200°C or lower so as to be used in a substrate using a material susceptible to heat such as a printed wiring board.

In addition, a calcination type electrically conductive paste is composed of a metal filler, glass, a solvent, and the like, and it is formed into an electrically conductive film by being printed on an electric conductor circuit pattern or a terminal and calcined by heating at from 600°C to 800°C so as to form a wire and an electrode. The calcination type electrically conductive paste is treated at a high temperature so that the metal fillers are sintered together to secure the conduction. This calcination type electrically conductive paste cannot be used in a printed wiring board using a resin material since it is treated at a high temperature for calcination in this manner, but it is possible to achieve low resistance as the metal fillers are sintered by a high temperature treatment. Hence, a calcination type electrically conductive paste is used in an external electrode of a laminated ceramic capacitor, or the like.

Meanwhile, the electromagnetic wave shield is used to prevent the generation of electromagnetic noises from an electronic device, and particularly in recent years, the housing of a personal computer or a mobile phone is made of a resin, and a method to form a thin metal film by a vapor deposition method or a sputtering method, a method to apply an electrically conductive coating material, and a method to shield electromagnetic waves by attaching an electrically conductive sheet to a required place, and the like have been thus proposed in order to secure the electrical conductivity of the housing. Among them, a method in which a metal filler is dispersed in a resin and applied and a method in which a metal filler is dispersed in a resin and processed into a sheet shape and the sheet is attached to a housing are frequently used as a method exhibiting an excellent degree of freedom since they do not require special equipment in the processing step.

However, in such a case of dispersing a metal filler in a resin and applying the resin or processing the resin into a sheet, the dispersion state of the metal filler in the resin is not uniform, and thus a method is required to eliminate the problem by increasing the filling factor of the metal filler in order to obtain electromagnetic wave shielding efficiency. However, in this case, problems that the flexibility of the resin sheet is impaired and the like are caused as well as the weight of the sheet increases by the addition of a large amount of metal filler. Hence, for example, it is described in Patent Document 1 that a thin sheet exhibiting an excellent electromagnetic wave shielding effect and also favorable flexibility can be formed by using a scaly metal filler in order to solve these problems.

A silver powder is frequently used as the metal filler to be used in these electrically conductive pastes and electromagnetic wave shields, but there is a tendency to use a silver-coated copper powder obtained by coating the surface of a copper powder that is less expensive than silver powder with silver so as to decrease the amount of silver used due to the cost saving trend.

As a method to coat the surface of a copper powder with silver, there are a method to coat the copper surface with silver by a substitution reaction and a method to coat the copper surface with silver in an electroless plating solution containing a reducing agent.

In the method to coat the copper surface with silver by a substitution reaction, a silver film is formed on the copper surface as the silver ion is reduced by the electrons generated when copper dissolves in the solution. For example, Patent Document 2 discloses a production method in which a silver film is formed on the copper surface by the substitution reaction between copper and the silver ion as a copper powder is put in a solution in which a silver ion is present. However, there is a problem in this substitution reaction method in that the amount of silver coated cannot be controlled since the dissolution of copper does not proceed any more when a silver film is formed on the copper surface.

In order to solve the problem, there is a method to coat silver by electroless plating solution containing a reducing agent. For example, Patent Document 3 proposes a method for producing a copper powder coated with silver by the reaction between a copper powder and silver nitrate in a solution in which a reducing agent is dissolved.

Here, as the copper powder, an electrolytic copper powder precipitated in a dendritic shape called a dendrite shape is known and it is characterized by a large surface area due to a dendritic shape thereof. In the case of using this in an electrically conductive film or the like, there is an advantage that the amount of an electrically conductive filler such as an electrically conductive paste can be decreased since the branches of dendrite overlap each other, conduction is likely to occur, and the number of contact points between particles is greater compared to that of a copper powder composed of spherical particles. For example, Patent Documents 4 and 5 propose a silver-coated copper powder in which the surface of a copper powder having a dendrite shape is coated with silver.

Specifically, Patent Documents 4 and 5 disclose dendrites characterized by long branches branched from the main stem as one that is further grown in a dendrite shape, and it is described that the silver-coated copper powder exhibits improved conduction as the contact points between particles are more than those between the dendrites of the prior art and it can enhance the electrical conductivity when being used in an electrically conductive paste or the like even though the amount of the electrically conductive powder is decreased.

On the other hand, the electrolytic copper powders are intertwined with one another more than the required amount in the case of being used in an electrically conductive paste or the like when dendrites of an electrolytic copper powder are developed, and it is thus pointed out in Patent Document 6 that it is extremely difficult to handle the electrolytic copper powder and the productivity decreases as the aggregation thereof is likely to occur and the fluidity thereof decreases. As a method for solving this problem, it is described in Patent Document 6 that it is possible to improve the strength of the electrolytic copper powder itself, to make it difficult for the dendrite to break, and to mold the electrolytic copper powder to have a high strength by adding a tungstate salt to an aqueous solution of copper sulfate that is an electrolytic solution for precipitating the electrolytic copper powder in order to increase the strength of the electrolytic copper powder itself.
Patent Document 1: Japanese Unexamined Patent Application, Publication No. 2003-258490
Patent Document 2: Japanese Unexamined Patent Application, Publication No. 2000-248303
Patent Document 3: Japanese Unexamined Patent Application, Publication No. 2006-161081
Patent Document 4: Japanese Unexamined Patent Application, Publication No. 2013-89576
Patent Document 5: Japanese Unexamined Patent Application, Publication No. 2013-100592
Patent Document 6: Japanese Patent No. 4697643

### DISCLOSURE OF THE INVENTION

### Problems to be Solved by the Invention

In order to secure the electrical conductivity, a dendritic shape having a three-dimensional shape is more likely to secure the contact points than a granular shape and is expected to secure high electrical conductivity as an electrically conductive paste or an electromagnetic wave shield. However, a silver-coated copper powder having a dendrite shape of the prior art is a dendrite characterized by a long branch branched from the main stem and has a long and branched shape so that it has a simple structure from the viewpoint of securing the contact point and does not have an ideal shape as a shape to effectively secure the contact point by using a smaller amount of silver-coated copper powder.

The present invention has been proposed in view of such circumstances, and an object thereof is to provide a dendritic silver-coated copper powder which can effectively secure the contact points when copper powders coated with silver come in contact with one another and exhibits excellent electrical conductivity as the surface is coated with silver, excellent uniform dispersibility required when being formed into a paste, and suppressed aggregation.

### Means for Solving the Problems

The inventors of the present invention have found out that a silver-coated copper powder which has a dendritic shape having a three-dimensional shape is constituted by a dendritic copper powder having a fine protruding dendritic shape on the main stem and the branches branched therefrom as well, and is obtained by coating the surface of the copper powder with silver exhibits excellent electrical conductivity, can secure sufficient contact points when the copper powders come in contact with one another, exhibits excellent dispersibility required when being formed into a paste, and can be suitably used in applications such as an electrically conductive paste, thereby completing the present invention. In other words, the present invention provides the following.
(1) A first aspect of the present invention is a silver-coated copper powder, in which a surface of a copper powder formed of copper particles gathered to constitute a dendritic shape having a plurality of branches is coated with silver, the copper particles having the surface coated with silver are an ellipsoid having a size in a range of from 0.2 µm to 0.5 µm as a minor axis diameter and from 0.5 µm to 2.0 µm as a major axis diameter, and an average particle diameter (D50) of the copper powder that is constituted as ellipsoidal copper particles gather and has the surface coated with silver is from 5.0 µm to 20 µm.
(2) A second aspect of the present invention is the silver-coated copper powder according to the first aspect, in which a diameter of a dendritic branch portion is from 0.5 µm to 2.0 µm in the copper powder having the surface coated with silver.
(3) A third aspect of the present invention is the silver-coated copper powder according to the first or second aspect, in which an amount of silver coated is from 1% by mass to 50% by mass with respect to 100% by mass of the entire silver-coated copper powder coated with silver.
(4) A fourth aspect of the present invention is the silver-coated copper powder according to any one of the first to third aspects, in which a BET specific surface area value is from 0.3 m²/g to 3.0 m²/g.
(5) A fifth aspect of the present invention is a metal filler including the silver-coated copper powder according to any one of the first to fourth aspects at a proportion of 20% by mass or more to the entire metal filler.
(6) A sixth aspect of the present invention is the metal filler according to the fifth aspect, including a spherical copper powder having an average particle diameter (D50) of from 0.5 µm to 10 µm.
(7) A seventh aspect of the present invention is the metal filler according to the sixth aspect, in which the spherical copper powder is a spherical silver-coated copper powder having a surface coated with silver, and an amount of silver coated on the spherical silver-coated copper powder is from 1% by mass to 50% by mass with respect to 100% by mass of the entire spherical silver-coated copper powder coated with silver.
(8) An eighth aspect of the present invention is an electrically conductive paste including the metal filler according to any one of the fifth to seventh aspects, a binder resin, and a solvent.
(9) A ninth aspect of the present invention is an electrically conductive coating material for electromagnetic wave shielding using the metal filler according to any one of the fifth to seventh aspects.
(10) A tenth aspect of the present invention is an electrically conductive sheet for electromagnetic wave shielding using the metal filler according to any one of the fifth to seventh aspects.

### Effects of the Invention

According to the silver-coated copper powder of the present invention, it is possible to effectively secure the contact points when the silver-coated copper powders come in contact with one another since it is constituted by a copper powder having a dendritic shape and the silver-coated copper powder exhibits high electrical conductivity since the surface thereof is coated with silver. In addition, the silver-coated copper powder exhibits excellent dispersibility required when being formed into a paste and it is thus possible to suppress the aggregation caused by intertwining of the copper powders due to a dendritic shape. Such a silver-coated copper powder can be suitably used in an electrically conductive paste, an electrically conductive coating material and an electrically conductive sheet, for electromagnetic wave shielding, and the like.

### BRIEF DESCRIPTION OF THE DRAWINGS

Fig. 1 is a diagram which schematically illustrates a specific shape of a dendritic copper powder before being coated with silver.
Fig. 2 is a photograph which illustrates an observation image when a dendritic copper powder before being coated with silver is observed through a scanning electron microscope at 10,000-times magnification.
Fig. 3 is a photograph which illustrates an observation image when a dendritic silver-coated copper powder is observed through a scanning electron microscope at 10,000-times magnification.
Fig. 4 is a photograph which illustrates an observation image when a dendritic silver-coated copper powder is observed through a scanning electron microscope at 30,000-times magnification.

### PREFERRED MODE FOR CARRYING OUT THE INVENTION

Hereinafter, specific embodiments (hereinafter, referred to as the "present embodiment") of the copper powder according to the present invention will be described in detail with reference to the drawings. Incidentally, the present invention is not limited to the following embodiments, and various modifications are possible without changing the essence of the present invention.

### <<1. Silver-coated copper powder>>

The silver-coated copper powder according to the present embodiment is one in which the surface of a copper powder formed of copper particles gathered to constitute a dendritic shape having a plurality of branches is coated with silver.

Specifically, in the silver-coated copper powder according to the present embodiment, the copper powder having a dendritic shape is a copper powder formed as copper particles which are an ellipsoid having a size in a range of from 0.2 µm to 0.5 µm as a minor axis diameter and from 0.5 µm to 2.0 µm as a major axis diameter and have the surface coated with silver gather. Moreover, the average particle diameter (D50) of the dendritic copper powder having the surface coated with silver is from 5.0 µm to 20 µm.

Hereinafter, the shape of the copper powder constituting the silver-coated copper powder will be described more specifically.

### «2. Shape of dendritic copper powder»

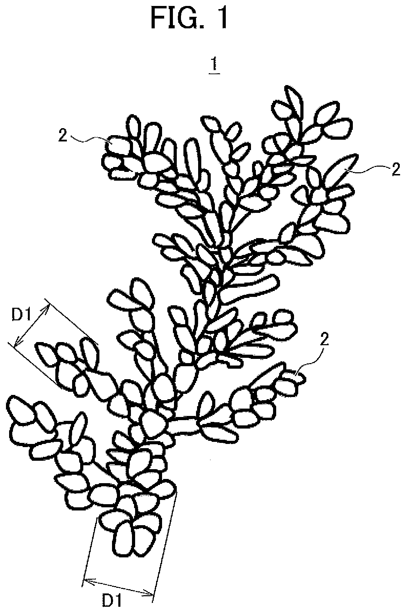

Fig. 1 is a diagram which schematically illustrates a specific shape of a dendritic copper powder which is not coated with silver and constitutes the silver-coated copper powder according to the present embodiment. As illustrated in this schematic diagram of Fig. 1, a copper powder 1 constituting the silver-coated copper powder has a dendritic shape having a plurality of branches and is composed of an assembly of fine copper particles 2 having an ellipsoidal shape. The silver-coated copper powder (hereinafter, also referred to as the "dendritic silver-coated copper powder") is formed as the surface of the dendritic copper powder 1 is coated with silver.

More specifically, the fine copper particles 2 are ellipsoidal copper particles having a size in a range of from 0.2 µm to 0.5 µm as a minor axis diameter and from 0.5 µm to 2.0 µm as a major axis diameter. Moreover, the average particle diameter (D50) of the dendritic copper powder 1 that is an assembly of the ellipsoidal copper particles 2 is from 5.0 µm to 20 µm. Incidentally, the minor axis diameter and major axis diameter of the fine copper particles that are coated with silver and constitute the silver-coated copper powder and the average particle diameter of the dendritic copper powder 1 are approximately the same even after the surface of the dendritic copper powder 1 is coated with silver.

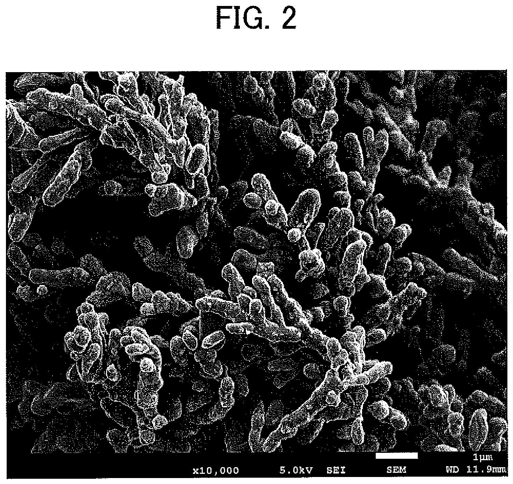

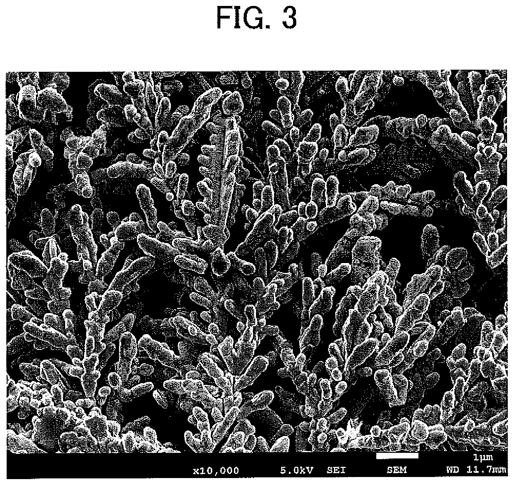

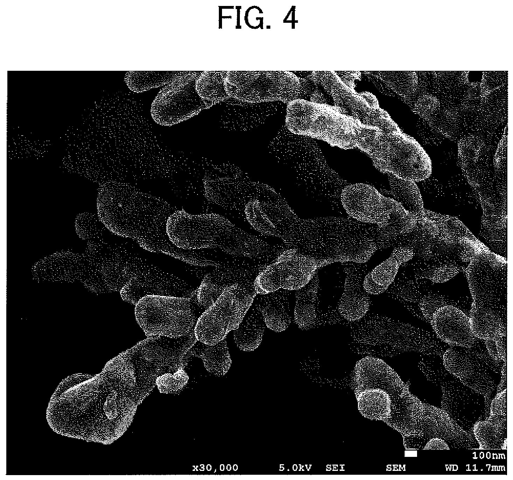

Fig. 2 is a photograph which illustrates an image of the dendritic copper powder that is not coated with silver and is observed through a scanning electron microscope (SEM). In addition, Figs. 3 and 4 are photographs which illustrate the dendritic silver-coated copper powder according to the present embodiment observed through an SEM. Incidentally, Fig. 2 is an image of the dendritic copper powder observed at 10,000-times magnification, Fig. 3 is an image of the silver-coated copper powder observed at 10,000-times magnification, and Fig. 4 is an image of the dendritic silver-coated copper powder observed at 30,000-times magnification.

As observed in Fig. 2 and Figs. 3 and 4, the silver-coated copper powder according to the present embodiment is constituted by a copper powder in a dendritic precipitated state. Specifically, this dendritic silver-coated copper powder is obtained as silver is coated on the surface of the dendritic copper powder 1 formed into a dendritic shape having a plurality of branches as the fine copper particles 2 gather, and the fine copper particles 2 has an ellipsoidal shape having a size of a minor axis diameter of 0.5 µm or less and a major axis diameter of 2.0 µm or less.

It is possible to have a great number of contact points when the dendritic silver-coated copper powders come in contact with one another as the shape of the fine copper particles 2 constituting the copper powder 1 is an elongated shape having a major axis diameter of 2.0 µm or less in this manner. In other words, as the dendritic silver-coated copper powder is an assembly of the fine copper particles 2 having a major axis diameter of 2.0 µm or less, fine protrusions are formed on the branch portion of the dendritic silver-coated copper powder and this makes it possible to secure a great number of contact points between the dendritic silver-coated copper powders, as it is confirmed in the observation results illustrated in Fig. 2 as well.

Meanwhile, the intervals between the dendritic branches decrease and a dense shape is formed as a whole so that the number of contact points between the dendritic silver-coated copper powders tends to rather decrease when the fine copper particles 2 have a long shape to have a major axis diameter of more than 2.0 µm. On the contrary, the protrusions are not formed when the major axis diameter of the fine copper particles is too short. Hence, the major axis diameter of the fine copper particles 2 is preferably from 0.5 µm to 2.0 µm.

In addition, the minor axis diameter of the fine copper particles 2 is 0.5 µm or less. The diameter ("D1" in the schematic diagram of Fig. 1) of the branch portion of the dendritic copper powder 1 increases in the case of gathering the fine copper particles 2 to form the copper powder 1 having a dendritic shape when the minor axis diameter is larger than 0.5 µm. The interval between the branches of the dendritic silver-coated copper powder obtained by coating the surface of the dendritic copper powder 1 with silver is narrowed and a dense shape is formed as a whole so that it is impossible to exert a three-dimensional dendritic effect when the diameter of the branch portion is large. On the contrary, the dendritic silver-coated copper powder is in a fine whisker-shaped state so that it is impossible to secure sufficient electrical conductivity in the case of bringing the dendritic silver-coated copper powders into contact with one another when the diameter of the branch portion is too small. Hence, it is possible to exert the effect of a three-dimensional dendritic shape and to secure sufficient electrical conductivity as the minor axis diameter of the fine copper particles 2 forming the dendritic silver-coated copper powder has a size of from 0.2 µm to 0.5 µm.

Furthermore, the diameter (D1) of the branch portion of the dendritic copper powder 1 formed as the fine copper particles 2 gather is preferably 2.0 µm or less. The interval between the branches of the dendritic copper powder 1 is narrowed and a dense shape is formed as a whole when the diameter of the branch portion exceeds 2.0 µm. On the other hand, when the diameter of the branch portion is too small, the strength of the dendritic silver-coated copper powder is insufficient, and there is thus a possibility that the branch portion of the copper powder is broken and the electrical conductivity is lost since the strength of the dendritic silver-coated copper powder is low particularly in the case of considering the flexibility when molding the dendritic silver-coated copper powder into an electrically conductive sheet. Hence, the diameter of the branch portion of the dendritic copper powder 1 is preferably from 0.5 µm to 2.0 µm.

Next, the size (average particle diameter (D50)) of the dendritic copper powder 1 is from 5.0 µm to 20 µm. Here, as it is also pointed out in Patent Document 6, there is a problem that the dendritic copper powders intertwine with one another and aggregate but are not uniformly dispersed in the resin in the case of being utilized as a metal filler of an electrically conductive paste or a resin for electromagnetic wave shield and a problem caused when wiring is formed by printing as the viscosity of the paste increases due to the aggregation in some cases as the problem of a dendritic copper powder. These are caused since the dendritic copper powder is large, and it is required to appropriately decrease the size of the dendritic copper powder in order to solve this problem while effectively utilizing the dendritic shape. However, it is impossible to secure a dendritic shape when the size of the dendritic copper powder is too small. Specifically, it is required to form a shape having a size of 5.0 µm or more in order to secure the effect of the dendritic shape.

It is possible to suppress an increase in viscosity of the paste as well as to favorably disperse the silver-coated copper powder in the resin by suppressing the aggregation thereof while effectively exerting the effect of a three-dimensional dendritic shape as the size, namely, the average particle diameter (D50) of the dendritic copper powder 1 of the silver-coated copper powder according to the present embodiment is from 5.0 µm to 20 µm and the silver-coated copper powder is constituted by the dendritic copper powder 1 having such a size as described above.

Incidentally, it is possible to obtain the same effect as the copper powder composed only of the dendritic copper powder when the dendritic copper powder having the shape as described above accounts for a predetermined proportion in the obtained copper powder when observed through an electron microscope although copper powders having shapes other than the shape are mixed therein. Specifically, copper powders having shapes other than the shape described above may be contained in the obtained copper powder as long as the dendritic copper powder having the shape described above accounts for 65% by number or more, preferably 80% by number or more, and more preferably 90% by number or more in the entire copper powders when observed through an electron microscope (for example, 500-times to 20,000-times).

### «3. Silver coating»

As described above, the silver-coated copper powder according to the present embodiment is formed as silver is coated on the surface of the dendritic copper powder 1 having a dendritic shape constituted as the fine copper particles 2 gather. Hereinafter, coating of the surface of the dendritic copper powder 1 described above with silver will be described.

In the silver-coated copper powder according to the present embodiment, the amount of silver coated with respect to the dendritic copper powder 1 is preferably from 1% by mass to 50% by mass with respect to 100% by mass of the entire silver-coated copper powder coated with silver. It is preferable that the amount of silver coated is as small as possible from the viewpoint of cost, but it is impossible to secure a uniform silver film on the copper surface and a decrease in electrical conductivity is thus caused when the amount is too small. Accordingly, the amount of silver coated is preferably 1% by mass or more, more preferably 2% by mass or more, and even more preferably 5% by mass or more with respect to 100% by mass of the entire silver-coated copper powder coated with silver.

On the other hand, it is not preferable that the amount of silver coated is too great from the viewpoint of cost, and there is a possibility that fine protrusions (see the schematic diagram of Fig. 1) which characterize the silver-coated copper powder according to the present embodiment disappear when the copper surface is coated with silver more than necessary. Hence, the amount of silver coated is preferably 50% by mass or less and more preferably 20% by mass or less with respect to 100% by mass of the entire silver-coated copper powder coated with silver.

In addition, in the silver-coated copper powder according to the present embodiment, the average thickness of silver coated on the surface of the dendritic copper powder 1 is about from 0.001 µm to 0.1 µm and more preferably from 0.02 µm to 0.03 µm. It is impossible to secure uniform silver coating and a decrease in electrical conductivity is caused when the thickness of silver coated is less than 0.001 µm on average. On the other hand, it is not preferable that the thickness of silver coated exceeds 0.1 µm on average from the viewpoint of cost and there is a possibility that fine protrusions on the surface disappear.

As described above, the average thickness of silver coated on the surface of the dendritic copper powder 1 is about from 0.001 µm to 0.1 µm, which is extremely small as compared to the minor axis diameter and major axis diameter of ellipsoidal copper particles constituting the dendritic copper powder. Hence, the minor axis diameter and major axis diameter of the ellipsoidal copper particles do not substantially change before and after the surface of the dendritic copper powder 1 is coated with silver.

As described above, the silver-coated copper powder according to the present embodiment is characterized by being constituted by a dendritic copper powder (dendritic copper powder having the surface coated with silver) formed as ellipsoidal copper particles having a size in a range of from 0.2 µm to 0.5 µm as a minor axis diameter and from 0.5 µm to 2.0 µm as a major axis diameter and the surface coated with silver gather and by having fine protrusions on the surface as illustrated in the schematic diagram of Fig. 1 and the photographs of Figs. 2 to 4. There is a BET specific surface area as an indicator representing the surface shape, and the value of the BET specific surface area of the silver-coated copper powder according to the present embodiment is preferably from 0.3 m²/g to 3.0 m²/g. Fine protrusions on the surface of the dendritic silver-coated copper powder are not sufficient and high electrical conductivity is not obtained in some cases when the BET specific surface area is less than 0.3 m²/g. On the other hand, when the BET specific surface area exceeds 3.0 m²/g, there is a possibility that the coating of the surface of the dendritic silver-coated copper powder with silver is not uniform and high electrical conductivity is not obtained and the fine copper particles 2 constituting the silver-coated copper powder are too fine and the silver-coated copper powder is in a fine whisker-shaped state so that the electrical conductivity decreases in some cases. Incidentally, the BET specific surface area can be measured in conformity with JIS Z 8830: 2013.

### «4. Production method of silver-coated copper powder»

Next, a method for producing the silver-coated copper powder having the characteristics described above will be described. Hereinafter, a method for producing the dendritic copper powder 1 constituting the silver-coated copper powder will be described first, and a method for obtaining a silver-coated copper powder by coating the dendritic copper powder 1 with silver will be subsequently described.

### <4-1. Production method of dendritic copper powder>

The dendritic copper powder 1 can be produced by a predetermined electrolytic method using, for example, a solution which exhibits acidity by sulfuric acid and contains a copper ion as an electrolytic solution.

Upon electrolysis, for example, the solution which exhibits acidity by sulfuric acid and contains a copper ion described above is accommodated in an electrolytic cell in which metallic copper is installed as the anode and a stainless steel plate, a titanium plate, or the like is installed as the cathode and an electrolytic treatment is conducted by applying a direct current to the electrolytic solution at a predetermined current density. This makes it possible to precipitate (electrodeposit) the dendritic copper powder 1 on the cathode along with energization. Particularly, in the present embodiment, it is possible to precipitate the dendritic copper powder 1 in which the ellipsoidal fine copper particles 2 gather to form a dendritic shape on the surface of the cathode by only the electrolysis without subjecting the copper powder which is obtained by electrolysis and has a granular shape or the like to mechanical deformation processing or the like using a medium such as a ball.

More specifically, as the electrolytic solution, for example, one that contains a water-soluble copper salt, sulfuric acid, an additive such as a polyether compound, and a chloride ion can be used.

The water-soluble copper salt is a copper ion source for supplying a copper ion, and examples thereof may include copper sulfate such as copper sulfate pentahydrate, copper chloride, and copper nitrate, but the water-soluble copper salt is not limited thereto. In addition, the concentration of the copper ion in the electrolytic solution can be set to about from 1 g/L to 20 g/L and preferably about from 5 g/L to 10 g/L.

Sulfuric acid is an acid that is used to prepare an electrolytic solution exhibiting acidity from sulfuric acid. The concentration of sulfuric acid in the electrolytic solution may be set to about from 20 g/L to 300 g/L and preferably about from 50 g/L to 150 g/L as the concentration of free sulfuric acid. This concentration of sulfuric acid affects the electrical conductivity of the electrolytic solution and it thus affects the uniformity of the copper powder obtained on the cathode.

As an additive, for example, a polyether compound can be used. This polyether compound contributes to the shape control of the copper powder to be precipitated together with the chloride ion to be described later, and it is thus possible to form the copper powder to be precipitated on the cathode into the dendritic copper powder 1 having a dendritic shape formed as the ellipsoidal fine copper particles 2 having a predetermined minor axis diameter and a predetermined major axis diameter gather.

The polyether compound is not particularly limited, but examples thereof may include polyethylene glycol (PEG) and polypropylene glycol (PPG). Incidentally, as the polyether compound, one kind may be added singly or two or more kinds may be added concurrently. In addition, the amount of the polyether compound added is preferably set to an amount so that the concentration of the polyether compound in the electrolytic solution is in a range of about from 0.1 g/L to 5 g/L.

The chloride ion can be contained in the electrolytic solution by adding a compound (chloride ion source) for supplying a chloride ion such as hydrochloric acid and sodium chloride thereto. The chloride ion contributes to the shape control of the copper powder to be precipitated. The concentration of the chloride ion in the electrolytic solution can be set to about from 1 mg/L to 1000 mg/L, preferably about from 25 mg/L to 800 mg/L, and more preferably about from 50 mg/L to 500 mg/L.

In the method for producing the dendritic copper powder according to the present embodiment, for example, the dendritic copper powder is produced by precipitating and generating a copper powder on the cathode through electrolysis using the electrolytic solution having the composition as described above. A known method can be used as the electrolysis method. For example, the current density is preferably set to a range of from 5 A/dm² to 30 A/dm² upon electrolysis using an electrolytic solution exhibiting acidity by sulfuric acid, and the electrolytic solution is energized while being stirred. In addition, the liquid temperature (bath temperature) of the electrolytic solution can be set, for example, to about from 20°C to 60°C. In addition, the time for electrolysis may be appropriately set depending on the concentration of the copper ion in the electrolytic solution and the like, and it can be set, for example, to about from 6 hours to 15 hours.

### <4-2. Coating method of silver (production of silver-coated copper powder)>

The dendritic silver-coated copper powder according to the present embodiment can be produced, for example, by coating the surface of the dendritic copper powder 1 fabricated by the electrolysis method described above with silver by using a reduction type electroless plating method or substitution type electroless plating method.

It is preferable to conduct washing before silver plating in order to coat the surface of the copper powder 1 with silver in a uniform thickness, and it is preferable to conduct washing while dispersing and stirring the dendritic copper powder 1 in the washing liquid. This washing treatment is preferably conducted in an acidic solution, and it is more preferable to use a polycarboxylic acid, which is also used as a reducing agent to be described later. After washing, filtration, separation, and water washing of the dendritic copper powder are appropriately repeated to obtain a water slurry in which the dendritic copper powder is dispersed in water. Incidentally, known methods may be used for the filtration, separation, and water washing.

Specifically, in the case of conducting silver coating by the reduction type electroless plating method, it is possible to coat the surface of the dendritic copper powder 1 with silver by adding a reducing agent and a silver ion solution to the water slurry obtained after washing the copper powder 1. Here, it is possible to more uniformly coat the surface of the dendritic copper powder 1 with silver by adding and dispersing the reducing agent in the water slurry in advance and then continuously adding the silver ion solution to the water slurry containing the reducing agent and the dendritic copper powder.

Various reducing agents can be used as the reducing agent, but the reducing agent is preferably a reducing agent having a weak reducing power that cannot reduce a complex ion of copper. As the weak reducing agent, a reducing organic compound can be used, and for example, a carbohydrate, a polycarboxylic acid and a salt thereof, an aldehyde, and the like can be used. More specific examples thereof may include grape sugar (glucose), lactic acid, oxalic acid, tartaric acid, malic acid, malonic acid, glycolic acid, sodium potassium tartrate, and formalin.

After the reducing agent is added to the water slurry containing the dendritic copper powder, it is preferable to conduct stirring or the like in order to sufficiently disperse the reducing agent. In addition, it is possible to appropriately add an acid or an alkali in order to adjust the water slurry to a desired pH. Furthermore, the dispersion of the reducing organic compound of a reducing agent may be accelerated by adding a water-soluble organic solvent such as an alcohol.

As the silver ion solution to be continuously added, those known as a silver plating solution can be used, but among them, it is preferable to use a silver nitrate solution. In addition, the silver nitrate solution is more preferably added as an ammoniacal silver nitrate solution since it easily forms a complex. Ammonia to be used for preparing the ammoniacal silver nitrate solution may be added to the silver nitrate solution, added to the water slurry together with the reducing agent in advance and dispersed, or simultaneously added to the water slurry as an ammonia solution different from the silver nitrate solution, or any method including a combination of these may be used.

It is preferable to gradually add the silver ion solution at a relatively slow rate upon adding the silver ion solution to the water slurry containing, for example, the dendritic copper powder 1 and the reducing agent, and this makes it possible to form a silver film having a uniform thickness on the surface of the dendritic copper powder 1. In addition, it is more preferable to keep the addition rate constant in order to increase the uniformity of the film thickness. Furthermore, the reducing agent and the like that are added to the water slurry in advance may be adjusted with another solution and gradually optionally added together with the silver ion solution.

In this manner, a dendritic silver-coated copper powder can be obtained by filtering, separating, washing with water, and then drying the water slurry to which the silver ion solution and the like are added. The methods for these treatments from the filtration are not particularly limited, and known methods may be used.

Meanwhile, the method to coat silver by the substitution type electroless plating method utilizes the difference in ionization tendency between copper and silver, and the silver ions in the solution are reduced by the electrons generated when the copper dissolves in the solution and silver thus obtained is precipitated on the copper surface in the method. Accordingly, it is possible to coat silver when the substitution type electroless silver plating solution is constituted by a silver salt as a silver ion source, a complexing agent, and a conductive salt as main components, but it is possible to add a surfactant, a brightener, a crystal modifier, a pH adjuster, a precipitation inhibitor, a stabilizer, and the like to the plating solution if necessary in order to more uniformly coat silver. The plating solution is not particularly limited in the production of the silver-coated copper powder according to the present embodiment as well.

More specifically, it is possible to use silver nitrate, silver iodide, silver sulfate, silver formate, silver acetate, silver lactate, and the like as the silver salt, and it is possible to react the silver salt with the dendritic copper powder 1 dispersed in the water slurry. The concentration of silver ion in the plating solution can be set to about from 1 g/L to 10 g/L.

In addition, the complexing agent forms a complex with the silver ion, as a typical complexing agent, it is possible to use citric acid, tartaric acid, ethylenediaminetetraacetic acid, nitrilotriacetic acid, and the like or an N-containing compound such as ethylenediamine, glycine, hydantoin, pyrrolidone, or succinimide, hydroxyethylidene diphosphonic acid, aminotrimethylene phosphonic acid, mercaptopropionic acid, thioglycol, thiosemicarbazide, and the like. The concentration of the complexing agent in the plating solution can be set to about from 10 g/L to 100 g/L.

In addition, as the conductive salt, it is possible to use an inorganic acid such as nitric acid, boric acid, or phosphoric acid, an organic acid such as citric acid, maleic acid, tartaric acid, or phthalic acid, or sodium, potassium, and ammonium salts thereof, and the like. The concentration of the conductive salt in the plating solution can be set to about from 5 g/L to 50 g/L.

The coating amount when silver is coated on the surface of the dendritic copper powder 1 can be controlled, for example, by changing the amount of silver input in the substitution type electroless plating solution. In addition, it is preferable to keep the addition rate constant in order to enhance the uniformity of the film thickness.

In this manner, a dendritic silver-coated copper powder can be obtained by filtering, separating, washing with water, and then drying the slurry of which the reaction has been completed. The methods for these treatments from the filtration are not particularly limited, and known methods may be used.

### «5. Application of electrically conductive paste, electrically conductive coating material for electromagnetic wave shielding, and electrically conductive sheet»

The silver-coated copper powder according to the present embodiment is constituted by the dendritic copper powder 1 formed as the ellipsoidal copper particles 2 having a size in a range of from 0.2 µm to 0.5 µm as a minor axis diameter and from 0.5 µm to 2.0 µm as a major axis diameter gather and the surface of the dendritic copper powder 1 is coated with silver. As described above, the shape of the silver-coated copper powder according to the present embodiment is characterized by fine protrusions formed on branch portions and a size (average particle diameter (D50)) of from 5.0 µm to 20 µm.

Here, the silver-coated copper powder of the prior art proposed in Patent Documents 4 and 5 does not include those having a shape formed as a great number of needle-shaped portions radially extend as a dendritic silver-coated copper powder characterized by a long branch branched from the main stem.

On the contrary, the shape of the dendritic silver-coated copper powder according to the present embodiment has fine protrusions formed on the branch portion and an average particle diameter (D50) of from 5.0 µm to 20 µm as described above. According to such a silver-coated copper powder, it is possible to secure more contact points between dendritic silver-coated copper powders than the dendritic silver-coated copper powder of the prior art, and it is thus possible to secure higher electrical conductivity than before. In addition, in the case of using this silver-coated copper powder as a metal filler, it is possible to suppress the aggregation of the silver-coated copper powder caused by intertwining thereof, to prevent the silver-coated copper powder from not being uniformly dispersed in the resin, and to suitably use the silver-coated copper powder in applications such as an electrically conductive paste, an electrically conductive coating material for electromagnetic wave shielding, and an electrically conductive sheet. Furthermore, an electrically conductive sheet which exhibits excellent flexibility is formed, for example, in the case of molding this dendritic silver-coated copper powder into an electrically conductive sheet since the branch portion has strength.

The dendritic silver-coated copper powder according to the present embodiment can be used by being mixed with a copper powder having another shape in the case of being utilized as a metal filler. At this time, the proportion of the dendritic silver-coated copper powder in the total amount of the copper powders is preferably 20% by mass or more, more preferably 60% by mass or more, and even more preferably 75% by mass or more. In this manner, in the case of using the dendritic silver-coated copper powder as a metal filler, the gap of the dendritic silver-coated copper powder is filled with a copper powder having another shape by mixing the copper powder having another shape together with the dendritic silver-coated copper powder as the copper powder, and this makes it possible to secure more contact points for securing electrical conductivity. In addition, as a result, it is also possible to decrease the total input amount of the dendritic silver-coated copper powder and a copper powder having another shape.

When the dendritic silver-coated copper powder is less than 20% by mass in the total amount of the copper powders to be used as the metal filler, the contact points among the dendritic silver-coated copper powders decrease and electrical conductivity as a metal filler decreases even if an increase in the number of contact points due to mixing of the dendritic silver-coated copper powder with a copper powder having another shape is taken into consideration.

The copper powder having another shape is preferably a spherical copper powder from the viewpoint of being able to be filled in the gap of the dendritic silver-coated copper powder in a greater amount. Furthermore, it is possible to further enhance the electrical conductivity by coating the surface of the spherical copper powder to be mixed with silver, thereby to be used as a spherical silver-coated copper powder. The amount of silver coated with respect to the spherical copper powder at this time is not particularly limited, but it is preferably from 1% by mass to 50% by mass with respect to 100% by mass of the entire spherical silver-coated copper powder coated with silver to be the same as the amount of silver coated on the dendritic silver-coated copper powder described above. This is for the same reason as the amount of silver coated on the dendritic silver-coated copper powder, and it is preferable that the amount of silver coated is as small as possible from the viewpoint of cost, but it is impossible to secure a uniform silver film on the surface of the spherical copper powder and a decrease in electrical conductivity is thus caused when the amount is too small. Accordingly, the lower limit value of the amount of silver coated is preferably 1% by mass or more, more preferably 2% by mass or more, and even more preferably 5% by mass or more with respect to 100% by mass of the entire spherical silver-coated copper powder coated with silver. In addition, it is not preferable that the amount of silver coated is too great from the viewpoint of cost. Accordingly, the upper limit value of the amount of silver coated is preferably 50% by mass or less and more preferably 20% by mass or less with respect to 100% by mass of the entire spherical silver-coated copper powder coated with silver.

In addition, the size of the spherical copper powder as the copper powder having another shape is not particularly limited, but the average particle diameter (D50) thereof is preferably from 0.5 µm to 10 µm and more preferably from 1.0 µm to 5.0 µm. The particle size is too small and the effect of securing the contact points obtained as the spherical copper powder is filled in the gap of the dendritic silver-coated copper powder is not sufficient when the average particle diameter of the spherical copper powder is less than 0.5 µm. On the other hand, the influence of the amount of the spherical copper powder filled is greater than the three-dimensional effect of the dendritic silver-coated copper powder and the spherical copper powder is filled more than necessary when the particle size of the spherical copper powder is too large. Due to these facts, the average particle diameter of the spherical copper powder is preferably from 0.5 µm to 10 µm and more preferably from 1.0 µm to 5.0 µm, and this makes it possible to effectively and appropriately fill the spherical copper powder in the gap of the dendritic silver-coated copper powder in a smaller filling amount and to sufficiently secure the contact points.

Incidentally, needless to say, it is not intended to limit the utilization of the dendritic silver-coated copper powder according to the present embodiment only as a metal filler.

In the case of forming an electrically conductive paste by utilizing the metal filler described above, it is not used under particularly limited conditions, but the electrically conductive paste can be obtained by a general method, for example, by mixing the metal filler with a binder resin and a solvent and, if necessary, further with a curing agent, a coupling agent, a corrosion inhibitor, and the like, and kneading the mixture.

The binder resin to be used at this time is not particularly limited, and those used in the prior art can be used. For example, an epoxy resin, a phenol resin, an unsaturated polyester resin, and the like can be used. In addition, terpineol, ethyl carbitol, carbitol acetate, butyl cellosolve, and the like, which have been used in the prior art, can be used as the solvent as well. In addition, 2-ethyl-4-methylimidazole and the like, which have been used in the prior art, can also be used as the curing agent. Furthermore, benzothiazole, benzimidazole, and the like, which have been used in the prior art, can also be used as the corrosion inhibitor.

It is possible to form various kinds of electric circuits by using the electrically conductive paste fabricated by utilizing the metal filler described above. In this case as well, it is not used under particularly limited conditions, but it is possible to utilize a circuit pattern forming method or the like which has been conducted in the prior art. For example, it is possible to form a printed wiring board, an electric circuit of various kinds of electronic parts, an external electrode, and the like by applying or printing the electrically conductive paste fabricated by utilizing the metal filler described above on a calcined substrate or a non-calcined substrate, heating, then pressing if necessary, curing, and baking it.

In addition, in the case of utilizing the metal filler described above as the material for electromagnetic wave shielding as well, the metal filler is not used under particularly limited conditions but can be used by a general method, for example, by being mixed with a resin.

For example, in the case of forming an electrically conductive coating material for electromagnetic wave shielding by utilizing the metal filler described above as well, the metal filler is not used under particularly limited conditions but can be used as an electrically conductive coating material by a general method, for example, by being mixed with a resin and a solvent and further with an antioxidant, a thickener, an anti-settling agent, and the like if necessary and kneaded together. The binder resin and solvent to be used at this time are not particularly limited, and those that have been used in the prior art can be used. For example, a vinyl chloride resin, a vinyl acetate resin, an acrylic resin, a polyester resin, a fluorocarbon resin, a silicone resin, a phenol resin, and the like can be used. In addition, with regard to the solvent as well, it is possible to use an alcohol such as isopropanol, an aromatic hydrocarbon such as toluene, an ester such as methyl acetate, a ketone such as methyl ethyl ketone, and the like which have been used in the prior art. In addition, with regard to the antioxidant as well, it is possible to use a fatty acid amide, a higher fatty acid amine, a phenylenediamine derivative, a titanate-based coupling agent, and the like, which have been used in the prior art.

In addition, in the case of forming an electrically conductive sheet for electromagnetic wave shielding by utilizing the metal filler described above as well, the resin to be used for forming the electromagnetic wave shielding layer of the electrically conductive sheet for electromagnetic wave shielding is not particularly limited, and those that have been used in the prior art can be used. For example, it is possible to appropriately use a thermoplastic resin, a thermosetting resin, a radiation-curing resin, and the like that are composed of various kinds of polymers and copolymers such as a vinyl chloride resin, a vinyl acetate resin, a vinylidene chloride resin, an acrylic resin, a polyurethane resin, a polyester resin, an olefin resin, a chlorinated olefin resin, a polyvinyl alcohol-based resin, an alkyd resin, and a phenol resin.

The method for producing the electromagnetic wave shielding material is not particularly limited, but for example, the electromagnetic wave shielding material can be produced by applying or printing a coating material in which a metal filler and a resin are dispersed or dissolved in a solvent on a substrate to form an electromagnetic wave shielding layer and drying the coating material to an extent to which the surface is solidified. In addition, it is possible to utilize a metal filler containing the silver-coated copper powder according to the present embodiment in the electrically conductive adhesive layer of an electrically conductive sheet.

### EXAMPLES

Hereinafter, the present invention will be described more specifically with reference to Examples together with Comparative Examples, but the present invention is not limited to the following Examples at all.

### <Evaluation method>

In Examples and Comparative Examples, the observation of shape, the measurement of average particle diameter, the measurement of BET specific surface area, the measurement of the specific resistance of the electrically conductive paste, and the evaluation of the electromagnetic wave shielding property were carried out by the following methods.

### (Observation of shape)

20 arbitrary fields of vision were selected in a field of vision at 10,000-times magnification through a scanning electron microscope (SEM) (model: JSM-7100F manufactured by JEOL Ltd.), and the appearance of the copper powder contained in the field of vision was observed.

### (Measurement of average particle diameter)

The average particle diameter (D50) was measured by using a laser diffraction/scattering method particle size distribution measuring instrument (HRA9320 X-100 manufactured by NIKKISO CO., LTD.).

### (BET specific surface area)

The specific surface area was measured using a specific surface area and pore distribution measuring apparatus (QUADRASORB SI manufactured by Quantachrome Instruments).

### (Measurement of specific resistance of electrically conductive paste)

The specific resistance value of the coating film was determined by measuring the sheet resistance value with a four-terminal method using a low resistivity meter (Loresta-GP MCP-T600 manufactured by Mitsubishi Chemical Corporation) and the film thickness of the coating film using a surface roughness and shape measuring instrument (SURFCO M130A manufactured by TOKYO SEIMITSU CO., LTD.) and dividing the sheet resistance value by the film thickness.

### (Electromagnetic wave shielding property)

The evaluation of the electromagnetic wave shielding property was carried out by measuring the attenuation factor of the samples obtained in the respective Examples and Comparative Examples by using an electromagnetic wave having a frequency of 1 GHz. Specifically, the level in the case of Comparative Example 1 in which the dendritic silver-coated copper powder was not used was evaluated as "Δ", a case in which the attenuation factor was worse than the level of Comparative Example 1 was evaluated as "×", a case in which the attenuation factor was more favorable than the level of Comparative Example 1 was evaluated as "O", and a case in which the attenuation factor was superior to the level of Comparative Example 1 was evaluated as "⊙".

In addition, it was confirmed whether the electromagnetic wave shielding property changed or not by bending the fabricated electromagnetic wave shield in order to evaluate the flexibility of the electromagnetic wave shield.

### [Example 1]

### <Fabrication of dendritic copper powder>

A titanium electrode plate having an electrode area of 200 mm × 200 mm and a copper electrode plate having an electrode area of 200 mm × 200 mm were installed in an electrolytic cell having a capacity for electrolytic solution of 100 L as the cathode and the anode, respectively, an electrolytic solution was put in the electrolytic cell, and a direct current was applied to this, thereby precipitating a copper powder on the cathode plate.

At this time, a solution having a composition in which the concentration of copper ion was 10 g/L and the concentration of sulfuric acid was 100 g/L was used as the electrolytic solution. In addition, polyethylene glycol (PEG) having a molecular weight of 400 (manufactured by Wako Pure Chemical Industries, Ltd.) as an additive was added to this electrolytic solution so as to have a concentration of 500 mg/L in the electrolytic solution, and a hydrochloric acid solution (manufactured by Wako Pure Chemical Industries, Ltd.) was further added thereto so that the concentration of chloride ion (chlorine ion) in the electrolytic solution was 50 mg/L.

Thereafter, an electric current was applied to the electrolytic solution having a concentration adjusted as described above so that the current density of the cathode was 20 A/dm² under a condition in which the electrolytic solution was circulated at a flow rate of 10 L/min by using a metering pump and the temperature thereof was maintained at 30°C, thereby precipitating a copper powder on the cathode plate.

The electrolytic copper powder precipitated on the cathode plate was mechanically scraped off to the cell bottom of the electrolytic cell and recovered, and the copper powder thus recovered was washed with pure water, then placed in a vacuum dryer, and dried.

The shape of the electrolytic copper powder thus obtained was observed by the method using a scanning electron microscope (SEM) described above, and as a result, the precipitated copper powder had a dendritic shape constituted as ellipsoidal copper particles having a minor axis diameter of from 0.2 µm to 0.5 µm and a major axis diameter of from 0.5 µm to 2.0 µm gathered. In addition, the average particle diameter (D50) of the dendritic copper powder formed as the elliptical copper particles gathered was from 5.0 µm to 20 µm. In addition, it was confirmed that a dendritic copper powder in which a diameter of the branch-shaped portion formed as the ellipsoidal copper particles gathered had a size of from 0.5 µm to 2.0 µm was formed.

### <Fabrication of dendritic silver-coated copper powder by reduction method>

Next, a silver-coated copper powder was fabricated by using the dendritic copper powder fabricated by the method described above.

In other words, 100 g of the dendritic copper powder thus fabricated was stirred in a 3% aqueous solution of tartaric acid for about 1 hour, then filtered, washed with water, and dispersed in 2 liters of ion exchanged water. To this, 2 g of tartaric acid, 2 g of glucose, and 20 ml of ethanol were added, 20 ml of 28% ammonia water was further added thereto and stirred, thereafter, an aqueous solution prepared by dissolving 23 g of silver nitrate in 1.5 liters of ion exchanged water, an aqueous solution prepared by dissolving 10 g of glucose, 10 g of tartaric acid, and 100 ml of ethanol in 300 ml of ion exchanged water, and 100 ml of 28% ammonia water were gradually added to the mixture over 60 minutes, respectively. The bath temperature at this time was 25°C.

After the addition of each aqueous solution was completed, the powder was filtered, washed with water, and dried over ethanol, thereby obtaining a dendritic silver-coated copper powder in which the surface of the dendritic copper powder was coated with silver. The silver-coated copper powder was recovered, and the amount of silver coated was measured to have a result of 10.5% by mass with respect to 100% by mass of the entire silver-coated copper powder coated with silver. In addition, the dendritic silver-coated copper powder thus obtained was observed through an SEM in a field of vision at 10,000-times magnification, and as a result, it was confirmed that a dendritic silver-coated copper powder in a state in which silver was uniformly coated on the surface of a dendritic copper powder before being coated with silver was formed. In addition, the BET specific surface area of the dendritic silver-coated copper powder thus obtained was measured to have a result of 1.4 m²/g.

### <Formation into electrically conductive paste>

Next, the dendritic silver-coated copper powder fabricated by the method described above was formed into a paste to fabricate an electrically conductive paste.

In other words, 60 g of the dendritic silver-coated copper powder thus fabricated was mixed with 15 g of a phenol resin (PL-2211 manufactured by Gunei Chemical Industry Co., Ltd.) and 10 g of butyl cellosolve (KANTO CHEMICAL CO., INC. Cica Special Grade), and the mixture was repeatedly kneaded by using a small kneader (Non-bubbling Kneader NBK-1 manufactured by NIHONSEIKI KAISHA LTD.) for 3 minutes at 1200 rpm three times to be formed into a paste. Upon pasting, the copper powder was uniformly dispersed in the resin without aggregating. The electrically conductive paste thus obtained was printed on glass by using a metal squeegee and cured for 30 minutes at temperatures of 150°C and 200°C in the air atmosphere, respectively.

The specific resistance value of the coating film obtained by curing was measured, as a result, it was 4.6 × 10⁻⁵ Ω·cm (curing temperature: 150°C) and 4.8 × 10⁻⁶ Ω·cm (curing temperature: 200°C), respectively, and it was found that the electrically conductive paste exhibits excellent electrical conductivity.

### [Example 2]

### <Fabrication of dendritic silver-coated copper powder by substitution method>

The surface of the copper powder was coated with silver by using 100 g of the dendritic copper powder fabricated in Example 1 and a substitution type electroless plating solution.

As the substitution type electroless plating solution, a solution having a composition obtained by dissolving 20 g of silver nitrate, 20 g of citric acid, and 10 g of ethylenediamine in 1 liter of ion exchanged water was used, and 100 g of dendritic copper powder was added to the solution and reacted by being stirred for 60 minutes. The bath temperature at this time was 25°C.

After the reaction was completed, the powder was filtered, washed with water, and dried over ethanol, thereby obtaining a dendritic silver-coated copper powder in which the surface of the dendritic copper powder was coated with silver. The silver-coated copper powder was recovered, and the amount of silver coated was measured to have a result of 10.9% by mass with respect to 100% by mass of the entire silver-coated copper powder coated with silver. In addition, the dendritic silver-coated copper powder thus obtained was observed through an SEM in a field of vision at 10,000-times magnification, and as a result, it was confirmed that a dendritic silver-coated copper powder in a state in which silver was uniformly coated on the surface of a dendritic copper powder before being coated with silver was formed. In addition, the BET specific surface area of the dendritic silver-coated copper powder thus obtained was measured to have a result of 1.8 m²/g.

### <Formation into electrically conductive paste>

Next, the dendritic silver-coated copper powder thus fabricated was formed into a paste to fabricate an electrically conductive paste.

In other words, 60 g of the dendritic silver-coated copper powder thus fabricated was mixed with 15 g of a phenol resin (PL-2211 manufactured by Gunei Chemical Industry Co., Ltd.) and 10 g of butyl cellosolve (KANTO CHEMICAL CO., INC. Cica Special Grade), and the mixture was repeatedly kneaded by using a small kneader (Non-bubbling Kneader NBK-1 manufactured by NIHONSEIKI KAISHA LTD.) for 3 minutes at 1200 rpm three times to be formed into a paste. Upon pasting, the copper powder was uniformly dispersed in the resin without aggregating. The electrically conductive paste thus obtained was printed on glass by using a metal squeegee and cured for 30 minutes at temperatures of 150°C and 200°C in the air atmosphere, respectively.

The specific resistance value of the coating film obtained by curing was measured, as a result, it was 4.2 × 10⁻⁵ Ω·cm (curing temperature: 150°C) and 4.9 × 10⁻⁶ Ω·cm (curing temperature: 200°C), respectively, and it was found that the electrically conductive paste exhibits excellent electrical conductivity.

### [Example 3]

The dendritic silver-coated copper powder fabricated in Example 1 was mixed with a spherical silver-coated copper powder and formed into a paste. Incidentally, the fabrication of dendritic copper powder for fabricating the dendritic silver-coated copper powder and the conditions until the dendritic silver-coated copper powder was fabricated by coating the dendritic copper powder with silver were the same as in Example 1, and a dendritic silver-coated copper powder having an amount of silver coated of 10.5% by mass with respect to 100% by mass of the entire silver-coated copper powder coated with silver was used.

Meanwhile, an electrolytic copper powder (electrolytic copper powder Cu-300 manufactured by Nexcel Japan. K.K.) having an average particle diameter (D50) of 30.5 µm was subjected to eight passes of grinding and pulverization at an air flow rate of 200 L/min, a grinding pressure of 10 kg/cm², and about 400 g/hour using a high pressure jet stream whirlpool vortex type jet mill (NJ type nano grinding mill (NJ-30) manufactured by TOKUJU CORPORATION). The copper powder thus obtained had a granular shape (granular copper powder) and an average particle diameter (D50) of 5.6 µm.

Thereafter, the granular copper powder thus obtained was subjected to a degreasing treatment by an alkaline aqueous solution and an oxide coating treatment by dilute sulfuric acid, thoroughly washed with pure water, and then subjected to a silver coating treatment by the same reduction method as in Example 1. The amount of silver coated on the spherical silver-coated copper powder thus obtained was 11.2% by mass with respect to 100% by mass of the entire spherical silver-coated copper powder coated with silver.

15 g of a phenol resin (PL-2211 manufactured by Gunei Chemical Industry Co., Ltd.) and 10 g of butyl cellosolve (KANTO CHEMICAL CO., INC. Cica Special Grade) were mixed with 40 g of the dendritic silver-coated copper powder fabricated by the method described above and 10 g of a spherical silver-coated copper powder, and the mixture was repeatedly kneaded by using a small kneader (Non-bubbling Kneader NBK-1 manufactured by NIHONSEIKI KAISHA LTD.) for 3 minutes at 1200 rpm three times to be formed into a paste. Upon pasting, the copper powder was uniformly dispersed in the resin without aggregating. The electrically conductive paste thus obtained was printed on glass by using a metal squeegee and cured for 30 minutes at temperatures of 150°C and 200°C in the air atmosphere, respectively.

The specific resistance value of the coating film obtained by curing was measured, as a result, it was 3.9 × 10⁻⁵ Ω·cm (curing temperature: 150°C) and 4.1 × 10⁻⁶ Ω·cm (curing temperature: 200°C), respectively, and it was found that the electrically conductive paste exhibits excellent electrical conductivity.

### [Example 4]

The dendritic silver-coated copper powder fabricated in Example 1 was dispersed in a resin to prepare an electromagnetic wave shielding material. Incidentally, the fabrication of dendritic copper powder for fabricating the dendritic silver-coated copper powder and the conditions until the dendritic silver-coated copper powder was fabricated by coating the dendritic copper powder with silver were the same as in Example 1, and a dendritic silver-coated copper powder having an amount of silver coated of 10.5% by mass with respect to 100% by mass of the entire silver-coated copper powder coated with silver was used.

100 g of a vinyl chloride resin and 200 g of methyl ethyl ketone were mixed, respectively, with 50 g of this dendritic silver-coated copper powder and the mixture was repeatedly kneaded by using a small kneader for 3 minutes at 1200 rpm three times to be formed into a paste. Upon pasting, the copper powder was uniformly dispersed in the resin without aggregating. This was applied on a substrate formed of a transparent polyethylene terephthalate sheet having a thickness of 100 µm by using a Mayer bar and dried to form an electromagnetic wave shielding layer having a thickness of 30 µm.

The electromagnetic wave shielding property was evaluated by measuring the attenuation factor by using an electromagnetic wave having a frequency of 1 GHz. The results thereof are presented in Table 1.

### [Example 5]

The dendritic silver-coated copper powder fabricated in Example 1 was mixed with a spherical silver-coated copper powder and dispersed in a resin to prepare an electromagnetic wave shielding material. Incidentally, the fabrication of dendritic copper powder for fabricating the dendritic silver-coated copper powder and the conditions until the dendritic silver-coated copper powder was fabricated by coting the dendritic copper powder with silver were the same as in Example 1, and a dendritic silver-coated copper powder having an amount of silver coated of 10.5% by mass with respect to 100% by mass of the entire silver-coated copper powder coated with silver was used.

The spherical silver-coated copper powder was fabricated by the same method as that described in Example 3, and a spherical silver-coated copper powder having an amount of silver coated of 11.8% by mass with respect to 100% by mass of the entire spherical silver-coated copper powder coated with silver was used.

100 g of a vinyl chloride resin and 200 g of methyl ethyl ketone were mixed with 30 g of this dendritic silver-coated copper powder and 10 g of a spherical silver-coated copper powder, respectively, and the mixture was repeatedly kneaded by using a small kneader for 3 minutes at 1200 rpm three times to be formed into a paste. Upon pasting, the copper powder was uniformly dispersed in the resin without aggregating. This was applied on a substrate formed of a transparent polyethylene terephthalate sheet having a thickness of 100 µm by using a Mayer bar and dried to form an electromagnetic wave shielding layer having a thickness of 30 µm.

The electromagnetic wave shielding property was evaluated by measuring the attenuation factor by using an electromagnetic wave having a frequency of 1 GHz. The results thereof are presented in Table 1.

### [Comparative Example 1]

A copper powder was precipitated on the cathode plate in the same manner as in Example 1 except that PEG as an additive and chlorine ion were not added to the electrolytic solution. The surface of the copper powder thus obtained was coated with silver in the same manner as in Example 1 to obtain a silver-coated copper powder. Incidentally, the amount of silver coated on the silver-coated copper powder was 11.2% by mass with respect to 100% by mass of the entire silver-coated copper powder coated with silver.

The shape of the copper powder thus obtained was observed through an SEM in a field of vision at 10,000-times magnification, and as a result, it was confirmed that the copper powder precipitated was a significantly large dendritic copper powder having a thickness (diameter) of the branch portion of more than 10 µm. In addition, the average particle diameter (D50) of the copper powder was 22.3 µm.

15 g of a phenol resin (PL-2211 manufactured by Gunei Chemical Industry Co., Ltd.) and 10 g of butyl cellosolve (KANTO CHEMICAL CO., INC. Cica Special Grade) were mixed with 60 g of the dendritic silver-coated copper powder fabricated by the method described above, and the mixture was repeatedly kneaded by using a small kneader (Non-bubbling Kneader NBK-1 manufactured by NIHONSEIKI KAISHA LTD.) for 3 minutes at 1200 rpm three times to be formed into a paste. Upon pasting, an increase in viscosity occurred whenever kneading was repeated. This was considered to be caused by aggregation of a part of the copper powder, and it was difficult to uniformly disperse the copper powder. The electrically conductive paste thus obtained was printed on glass by using a metal squeegee and cured for 30 minutes at temperatures of 150°C and 200°C in the air atmosphere, respectively.

The specific resistance value of the coating film obtained by curing was measured, as a result, it was 6.7 × 10⁻⁴ Ω·cm (curing temperature: 150°C) and 3.1 × 10⁻⁴ Ω·cm (curing temperature: 200°C), respectively, and the electrically conductive paste thus obtained had an extremely high specific resistance value and exhibited poorer electrical conductivity as compared to the electrically conductive pastes obtained in Examples (Examples 1 to 3).

### [Comparative Example 2]

The properties of the electrically conductive paste with a spherical silver-coated copper powder were evaluated and compared to the properties of the electrically conductive pastes fabricated by using the dendritic silver-coated copper powders of Examples. Incidentally, the spherical silver-coated copper powder used was fabricated by the same method as that described in Example 3, and a spherical silver-coated copper powder having an amount of silver coated of 11.2% by mass with respect to 100% by mass of the entire silver-coated copper powder coated with silver was used.

15 g of a phenol resin (PL-2211 manufactured by Gunei Chemical Industry Co., Ltd.) and 10 g of butyl cellosolve (KANTO CHEMICAL CO., INC. Cica Special Grade) were mixed with 60 g of this dendritic silver-coated copper powder, and the mixture was repeatedly kneaded by using a small kneader (Non-bubbling Kneader NBK-1 manufactured by NIHONSEIKI KAISHA LTD.) for 3 minutes at 1200 rpm three times to be formed into a paste. Upon pasting, the copper powder was uniformly dispersed in the resin without aggregating. The electrically conductive paste thus obtained was printed on glass by using a metal squeegee and cured for 30 minutes at temperatures of 150°C and 200°C in the air atmosphere, respectively.

The specific resistance value of the coating film obtained by curing was measured, as a result, it was 3.4 × 10⁻⁴ Ω·cm (curing temperature: 150°C) and 1.1 × 10⁻⁴ Ω·cm (curing temperature: 200°C), respectively, and the electrically conductive paste thus obtained had an extremely high specific resistance value and exhibited poorer electrical conductivity as compared to the electrically conductive pastes obtained in Examples (Examples 1 to 3).

### [Comparative Example 3]

The properties of the electromagnetic wave shielding material with a spherical silver-coated copper powder were evaluated and compared to the properties of the electromagnetic wave shielding material fabricated by using the dendritic silver-coated copper powder of Example 4. Incidentally, the spherical silver-coated copper powder used was fabricated by the same method as that described in Example 3, and a spherical silver-coated copper powder having an amount of silver coated of 11.2% by mass with respect to 100% by mass of copper was used.

100 g of a vinyl chloride resin and 200 g of methyl ethyl ketone were mixed with 50 g of this dendritic silver-coated copper powder, respectively, and the mixture was repeatedly kneaded by using a small kneader for 3 minutes at 1200 rpm three times to be formed into a paste. Upon pasting, the copper powder was uniformly dispersed in the resin without aggregating. This was applied on a substrate formed of a transparent polyethylene terephthalate sheet having a thickness of 100 µm by using a Mayer bar and dried to form an electromagnetic wave shielding layer having a thickness of 30 µm.

The electromagnetic wave shielding property was evaluated by measuring the attenuation factor by using an electromagnetic wave having a frequency of 1 GHz. The results thereof are presented in Table 1.

**[Table 1]**

| | Input amount of silver-coated copper powder (g) | | Properties of electrically conductive paste (×10⁻⁶Ωcm) | | Properties of electromagnetic wave shield | |
|---|---|---|---|---|---|---|
| | Dendritic | Particulate | 150°C | 200°C | Plane | Bending |
| Example 1 | 60 | 0 | 46 | 4.8 | - | - |
| Example 2 | 60 | 0 | 42 | 4.9 | - | - |
| Example 3 | 40 | 10 | 39 | 4.1 | - | - |
| Example 4 | 50 | 0 | - | - | ⊚ | ○ |
| Example 5 | 30 | 10 | - | - | ⊚ | ○ |
| Comparative Example 1 | 60 | 0 | 670 | 310 | - | - |
| Comparative Example 2 | 0 | 60 | 340 | 110 | - | - |
| Comparative Example 3 | 0 | 50 | - | - | Δ | × |

### EXPLANATION OF REFERENCE NUMERALS

1 Copper powder (dendritic copper powder)
2 Copper particles (fine copper particles)
D1 Diameter of branch portion

## Claims

1. A silver-coated copper powder, wherein
a surface of a copper powder formed of copper particles gathered to constitute a dendritic shape having a plurality of branches is coated with silver,
the copper particles having the surface coated with silver are an ellipsoid having a size in a range of from 0.2 µm to 0.5 µm as a minor axis diameter and from 0.5 µm to 2.0 µm as a major axis diameter, and
an average particle diameter (D50) of the copper powder that is constituted as ellipsoidal copper particles gather and has the surface coated with silver is from 5.0 µm to 20 µm.

2. The silver-coated copper powder according to claim 1, wherein a diameter of a dendritic branch portion is from 0.5 µm to 2.0 µm in the copper powder having the surface coated with silver.

3. The silver-coated copper powder according to claim 1 or 2, wherein an amount of silver coated is from 1% by mass to 50% by mass with respect to 100% by mass of the entire silver-coated copper powder coated with silver.

4. The silver-coated copper powder according to any one of claims 1 to 3, wherein a BET specific surface area value is from 0.3 m²/g to 3.0 m²/g.

5. A metal filler comprising the silver-coated copper powder according to any one of claims 1 to 4 at a proportion of 20% by mass or more to the entire metal filler.

6. The metal filler according to claim 5, comprising a spherical copper powder having an average particle diameter (D50) of from 0.5 µm to 10 µm.

7. The metal filler according to claim 6, wherein
the spherical copper powder is a spherical silver-coated copper powder having a surface coated with silver, and
an amount of silver coated on the spherical silver-coated copper powder is from 1% by mass to 50% by mass with respect to 100% by mass of the entire spherical silver-coated copper powder coated with silver.

8. An electrically conductive paste comprising the metal filler according to any one of claims 5 to 7, a binder resin, and a solvent.

9. An electrically conductive coating material for electromagnetic wave shielding comprising the metal filler according to any one of claims 5 to 7.

10. An electrically conductive sheet for electromagnetic wave shielding comprising the metal filler according to any one of claims 5 to 7.
